# EUROPEAN PATENT APPLICATION

(11) **EP 4 668 275 A1**
(43) Date of publication of application: **24.12.2025**
(21) Application number: 25182056.9
(22) Date of filing: 11.06.2025
(51) Int. Cl.: G11C 29/52, G06F 11/10, G06F 12/02, G11C 7/04, G11C 7/10, G11C 16/34, G11C 29/02, G11C 29/04, G11C 29/12, G11C 29/42, G11C 29/44

(54) **MEMORY DEVICE USING MAINTENANCE MODE COMMAND FOR SCRUB OPERATIONS**

(30) Priority: 20.06.2024 US 202463662023 P; 15.05.2025 US 202519209573
(71) Applicant: Micron Technology, Inc, Boise ID 83707 (US)
(72) Inventor: MIRICHIGNI, Graziano, 20871 VIMERCATE (MONZA E BRIANZA) (IT); CAPRI', Antonino, 24128 BERGAMO (IT); SFORZIN, Marco, 20063 CERNUSCO SUL NAVIGLIO (MILANO) (IT); PORTER, John D., Boise, ID 83716 (US); KERSTETTER, Bryan, Boise, ID 83716 (US)
(74) Representative: Pio, Federico

(57) **Abstract**

Systems, methods, and apparatus for memory management operations in a memory device. In one approach, an external controller (e.g., ASIC controller) selects a directed scrub or a periodic scrub by issuing an encoded maintenance mode command to a local controller on a memory component managed by the external controller. The selection of the type of command can be based on a context of operation (e.g., signals provided by the memory component). In one example, the directed scrub is selected by the external controller based on error signals provided from error correction circuitry on the memory component during a read operation.

## Description

### FIELD OF THE TECHNOLOGY

At least some embodiments disclosed herein relate to memory devices in general, and more particularly, but not limited to memory devices that perform memory management operations (e.g., scrubbing).

### BACKGROUND

Memory devices can include semiconductor circuits that provide electronic storage of data for a host system (e.g., a server or other computing device). Memory devices may be volatile or non-volatile. Volatile memory requires power to maintain data, and includes devices such as random-access memory (RAM), static random-access memory (SRAM), dynamic random-access memory (DRAM), or synchronous dynamic random-access memory (SDRAM), among others. Non-volatile memory can retain stored data when not powered, and includes devices such as flash memory, read-only memory (ROM), electrically erasable programmable ROM (EEPROM), erasable programmable ROM (EPROM), resistance variable memory, such as phase change random access memory (PCRAM), resistive random-access memory (RRAM), or magnetoresistive random access memory (MRAM), among others.

Host systems (e.g., a host device) can include a host processor, a first amount of host memory (e.g., main memory, often volatile memory, such as DRAM) to support the host processor, and one or more storage systems (e.g., non-volatile memory, such as flash memory) that provide additional storage to retain data in addition to or separate from the main memory.

A storage system, such as a solid-state drive (SSD), can include a memory controller and one or more memory devices, including a number of (e.g., multiple) dies or logical units (LUNs). In certain examples, each die can include a number of memory arrays and peripheral circuitry thereon, such as die logic or a die processor. The memory controller can include interface circuitry configured to communicate with a host device (e.g., the host processor or interface circuitry) through a communication interface (e.g., a bidirectional parallel or serial communication interface). The memory controller can, for example, receive commands or operations from the host system in association with memory operations or instructions, such as read or write operations to transfer data (e.g., user data and associated integrity data, such as error data or address data, etc.) between the memory devices and the host device, erase operations to erase data from the memory devices, perform drive management operations (e.g., data migration, garbage collection, block retirement), etc.

Many memory devices, particularly non-volatile memory devices, such as NAND flash devices, etc., frequently relocate data or otherwise manage data in the memory devices (e.g., garbage collection, wear leveling, data scrubbing, drive management, etc.). NAND flash is a type of flash memory constructed using NAND logic gates. Altematively, NOR flash is a type of flash memory constructed using NOR logic gates.

Volatile memory devices such as DRAM typically refresh stored data. For example, refresh is activating and then precharging a row. At activation time the data in the cells are sensed (implicitly read), and at precharge time the data is written back to the cells (implicitly written).

Storage devices can have controllers that receive data access requests from host computers and perform programmed computing tasks to implement the requests in ways that may be specific to the media and structure configured in the storage devices. In one example, a flash memory controller manages data stored in flash memory and communicates with a computing device. In some cases, flash memory controllers are used in solid-state drives for use in mobile devices, or in SD cards or similar media for use in digital cameras.

Firmware can be used to operate a flash memory controller for a particular storage device. In one example, when a computer system or device reads data from or writes data to a flash memory device, it communicates with the flash memory controller.

Although current memory technologies provide for various functionality and benefits, situations often arise that may potentially cause degradation to the memory devices, potential data loss, damage to memory cells of the memory devices, among potential harmful effects to the memory devices. For example, certain memory cells of a memory array may be the target of a disproportionate number of read operations, write operations, other operations, or a combination thereof, when compared to other memory cells of the memory array. In such instances, such memory cells may wear out faster than other less-frequently-used memory cells.

Various techniques exist for extending the life of memory cells and balancing memory usage in memory devices. For example, wear leveling is a memory management technique that can extend the useful life of the memory cells of a device by effectively spreading memory usage across the various sections of the memory array so that the sections experience comparable memory usage. Wear leveling, for example, may involve transferring data from source memory rows located in a section of a memory array to target rows that may be located in another section of the memory array and then mapping the addresses of the source memory rows to addresses corresponding to the target memory rows. The transferred data can be scrubbed to correct any errors. Memory managementtechnologies may be enhanced to reduce the amountof memory resources utilized to conduct memory management, reduce errors in data and error correction bits, and further extend the life of memory.

### BRIEF DESCRIPTION OF THE DRAWINGS

The embodiments are illustrated by way of example and not limitation in the figures of the accompanying drawings in which like references indicate similar elements.
**FIG. 1** shows a memory device that performs memory management operations on one or more memory arrays in response to commands received from an external controller, in accordance with some embodiments.
**FIG. 2** shows a code word ECC engine used to correct errors for data stored in pages in a memory array, in accordance with some embodiments.
**FIG. 3** shows sense amplifier latches to hold data associated with memory cells of a memory array, in accordance with some embodiments.
**FIG. 4** shows a data path for read and write operations for a host device for each of multiple banks in a memory device, in accordance with some embodiments.
**FIG. 5** shows error correction circuitry for scrubbing code words from a bank of a memory array, in accordance with some embodiments.
**FIG. 6** shows an example of a command address table for a maintenance mode command, in accordance with some embodiments.
**FIG. 7** shows an example of selection of a maintenance mode command using command address bits, in accordance with some embodiments.
**FIG. 8** shows exemplary commands and timing used in a read operation.
**FIG. 9** shows exemplary commands and timing for a directed scrub operation, in accordance with some embodiments.
**FIG. 10** shows exemplary commands and timing for periodic scrub operations, in accordance with some embodiments.
**FIG. 11** shows timing parameters for maintenance mode commands, in accordance with some embodiments.
**FIG. 12** shows a method to perform memory management operations on one or more memory arrays, in accordance with some embodiments.

### SUMMARY

The invention is as defined in independent claims; optional embodiments are defined in dependent claims.

### DETAILED DESCRIPTION

The following disclosure describes various embodiments for performing memory management operations (e.g., error correction to scrub stored data) for one or more memory arrays in a memory device. In some embodiments, a scrubbing operation is selected by an external controller based on an operating context of the memory device. The external controller sends a corresponding encoded memory management command to the memory device (e.g., memory die or component).

At least some embodiments herein relate to a volatile (e.g., DRAM) or non-volatile memory (e.g., flash memory or non-volatile RAM) device that selects scrubbing operations to control an error rate for stored data. In some embodiments, a volatile memory device uses error correction circuitry for scrubbing data at a selected address location in memory (e.g., error check and scrub for an identified row of data in a DRAM). These memory devices may, for example, store data used by a host device (e.g., a computing device of an autonomous vehicle, or another computing device that accesses data stored in the memory device). In one example, the memory device is a solid-state drive mounted in an electric vehicle.

Memory scrubbing involves reading data from memory locations, correcting bit errors (if any) using an error correction code (ECC), and writing the corrected data back to the same or a different location. As the density of memory arrays increases, individual memory cells become increasingly vulnerable to errors in stored data (e.g., soft errors).

An ECC memory stores data along with parity data used to correct, for example, a single bit error per word. The ECC memory uses the parity data to support scrubbing of the memory content. For example, if a memory controller scans systematically through a memory, single bit errors can be detected, erroneous bits can be determined using the ECC parity data, and the corrected data can be written back to the memory.

Each memory location is checked periodically, before multiple bit errors within the same word are likely to occur. To avoid interfering with regular memory requests from a host, scrubbing is typically done during idle periods.

Regular or normal memory reads are checked for ECC errors, but this may be confined to a limited range of addresses keeping other memory locations unchecked for a long time. Scrubbing can enable checking all memory locations within a selected time. Thus, memory scrubbing increases reliability of the memory device.

In some cases, memory devices provide only limited control over scrubbing operations (e.g., selecting of a scrubbing frequency). However, this can cause the technical problem of insufficient control over scrubbing operations to properly handle complex failure mechanisms. For example, this lack of control can lead to an unacceptable raw bit error rate (RBER) when reading data requested by a host and performing a read operation. For example, this lack of control can lead to inability to customize scrubbing to address particularfailure mechanisms that may vary for different portions of a memory (e.g., due to differing usage frequency and/or other conditions associated with specific physical locations on a chip and/or other context of the memory). Thus, there is a need for improved control over selection and/or configuration of scrubbing operations.

Storage elements in a memory device may degrade and fail with use. In some cases, a memory device may implement an algebraic wear leveling scheme in order to mitigate wear in an on-die ECC scheme. This wear leveling scheme will adjust logical-to-physical address mapping for a wear leveling pool as part of performing the wear leveling. Each wear leveling pool uses circuitry to facilitate wear leveling movements and logical-to-physical address translation. In one example, a wear leveling pool is an individual bank.

In some cases, before source data is written to a target row during the wear leveling, an ECC scrub is performed on the source data. Scrubbing correctable errors during wear leveling prevents the accumulation of correctable errors that could aggregate into an uncorrectable error. Thus, scrubbing correctable errors during wear leveling reduces the likelihood of experiencing uncorrectable errors.

In one example, an algebraic-based wear leveling scheme uses an additional row in a memory array to allow wear leveling movements. The wear leveling movements consist of moving source data (e.g., pointed to by a source pointer) to a target row (e.g., pointed to by a target pointer). A physical address is determined by adding a present or next offset to a logical address. Given a logical address, and assuming the target pointer and source pointer are maintained properly, then an algorithm permits the physical address to be determined. Source data at a source address is moved to a target address. The target pointer and source pointer are updated after each wear leveling movement. The offset pointer is regularly updated according to the movements.

In one example, wear leveling movements may be triggered by an activity-based (e.g., a refresh management (RFM) command for DRAM) or periodic memory management (MM) command (e.g., based on a repeating time interval). Each memory management command causes a portion of a wear leveling movement to occur for each bank in a pool (e.g., a memory management group). Each memory management group can contain one or more banks.

In one example, a memory device is a flash memory in an SSD, or a device using another memory technology having cells that sustain sufficient wear to require wear leveling to ensure sufficient lifetime. A wear leveling pool includes addresses that are cycled through wear leveling movements so that any given logical address (e.g., for stored user data) over time could be associated with any physical address in the pool. An activity-based refresh management command (RFM) for DRAM is used to trigger wear leveling movements. In one example, the wear leveling movement is broken up into two portions using a holding register. Data goes through an ECC scrub when being moved from a source address to the holding register. Data is then moved one code word at a time from the holding register to a target address.

In one example, each bank in a memory device has its own wear-leveling engine, and multiple banks can be maintained in parallel. Wear leveling occurs in parallel for all of the banks.

In some cases, an on-die wear leveling algorithm for memory devices (e.g., DRAM, non-volatile RAM, or NOR flash memory) is based on a start-gap algorithm. The algorithm is used for a pool that is a set of memory locations (e.g., which store user data) in a memory array(s). The pool contains an additional location (referred to as a gap location, or sometimes as simply a gap) that moves (e.g., rolls or cycles) through the pool. Moving the gap location allows the memory device to remove the correlation between logical addresses of the user data and physical addresses in the memory at which the user data is stored. This distributes accesses to the physical memory evenly along the whole pool.

A start-gap algorithm is applied to a pool of memory cells in a memory device. The larger the pool, the longer the lifetime of the memory device. The dimension of the pool is limited by the endurance of the memory technology used in the memory device (e.g., endurance as measured by a number of reads and/or writes to a given cell). The start-gap algorithm needs to move locations that are being heavily accessed before they wear out. The gap location moves through locations in the pool.

In one example, the gap location is moved every time a memory management (MM) command is received by a local controller or other logic circuitry of the memory device. Moving the gap location requires copying the user data to be moved to a new physical address location, and changing start location and gap location pointers used in implementing the start-gap algorithm.

In one example, the issuance of a memory management command can be based on time or activity. For example, memory management can be performed every 100 write commands. In one example, a memory die receives this command from an external memory controller.

However, the above wear leveling approaches provide only limited control over the wear leveling and/or scrubbing operations. This limits or prevents customizing memory management by a memory controller such as by configuring in real-time a varying mix of wear leveling, scrubbing, and/or other memory management operations based on a real-time context of memory operation (e.g., as based on observed error conditions during reads or writes, a memory temperature, specific bank access or other activity).

As indicated above, on receiving read commands from an external memory controller by a memory die, the data and parity in a memory array of the memory die are sensed. The sensed data and parity are input into a code word ECC engine within the memory die. The code word ECC engine determines if there are any errors. If there are correctable errors, the data is corrected before being sent to DQ pins of the memory die and then sent to the memory controller. The memory controller receives the read data with the corrected data while the array data of the memory die is unaltered. Correcting the array data requires a read modify write operation.

From the perspective of the memory controller, the read is successful with no errors. In actuality, the code word that was read had some correctable error that existed in the array. However, many controllers are not notified of this issue. This can lead to the problem in which, over time, errors could aggregate and cause the correctable error to become an uncorrectable error. This uncorrectable error is not able to be corrected by the code word ECC engine. Therefore, the code word ECC engine must leave the data as is when read. In this case, the memory controller will now receive uncorrectable data that may cause a system failure.

In some cases, the manifestation of this uncorrectable error can be avoided if the memory die alerts the external memory controller of the corrected error. For example, ECC Error Alert (EEA) provides such an alert to the controller. At this point, after being notified of the issue by the memory die, the memory controller has the option to perform some action to help remedy the issue. One action might be to simply write back the read data to the address that flagged an issue via EEA.

The memory controller received the corrected data with an EEA flag indicating a correctable error occurred. Therefore, the memory controller could write that corrected data back to the array by issuing a write command to the appropriate address of the code word. This write command will result in new parity being generated for the corrected data. The corrected data and new parity would then be written into the array. However, writing corrected data back to the array causes the problem of excessive power consumption due to transferring the corrected data from the external controller back to the memory die. Various embodiments of the present disclosure provide a technological solution to one or more of the above technical problems. In one embodiment, a memory system includes error correction circuitry located on a memory die and a controller that issues commands for managing memory array(s) on the memory die. The error correction circuitry is used to correct any errors in data read from a memory array.

In general, the controller can be an external controller on a different die from the memory array(s) being managed, or a local controller on a same die as the memory array(s) being managed. In one example, the external controller is an ASIC or CXL controller for a memory module containing memory components managed by the external controller. In one example, the local controller is a processing device or logic circuitry on a memory component (e.g., a memory die). In one example, the local controller receives commands from an external controller.

The external or local controller determines at least one characteristic (e.g., a bit error) associated with accessing data in the memory array(s). The controller selects, based on the determined characteristic, a memory management operation to perform using the error correction circuitry. For example, the characteristic is determined based on signals provided by an ECC engine (e.g., ECC error alert signals (EEA)). For example, the characteristic is a raw bit error rate (RBER) for the accessed data.

A memory management operation is generally initiated using a memory management (MM) command. As used herein, a memory management (MM) command is sometimes referred to as a maintenance mode (MM) command. Maintenance mode commands include, for example, a directed scrub command and a periodic scrub command, as discussed below.

As used herein, a scrubbing operation is sometimes referred to simply as a scrub operation or a scrub. Scrubbing operations include, for example, a directed scrub and a periodic scrub.

In one embodiment, a memory management command is issued with a directed scrub option instead of writing back the corrected data with the write command, such as discussed above. This is beneficial in that power is saved due to the corrected data received by the external controller does not have to be transferred back to the memory die. Further, a greater number of code words (e.g., that exist on the same page of the code word that flagged an EEA issue) may be scrubbed beyond the single code word that flagged an EEA issue (e.g., in the case of the earlier described write procedure to scrub the correctable error).

In one embodiment, additional bits are added to the memory management command to provide the memory controller with the ability to specify various memory management operations, in addition to the directed scrub, that could be triggered by a controller.

In one embodiment, a communication mechanism between a memory controller and a memory die is provided. The memory controller issues a read command to the memory die. A code word ECC engine of the memory die corrects a correctable error. Corrected data and an EEA alert are sent from the memory die to the memory controller.

Upon receiving an EEA alert status that is beyond a scrub threshold, the memory controller issues a memory management command with the directed scrub option selected to the memory die. Upon receiving (from the memory controller) the memory management command with the directed scrub option selected, a local controller or logic circuitry on the memory die performs a scrub to the bank or banks associated with the memory management command, and to the last activate address for each of the banks.

In one embodiment, each bank has a set of row address latches. On each activate cycle these row address latches are updated with the appropriate address. The state of these row address latches is not updated until the next activate operation is issued to that particular bank. The directed scrub as described herein takes advantage of this behavior by performing a scrub to the address that exists in these latches (e.g., the row address of the previous activate cycle which is associated with the EEA flag).

The above communication mechanism between the memory controller and memory component helps to assure data integrity during usage of a memory system. In the absence of the communication mechanism between the memory die and memory controller of correctable errors (e.g., EEA), over time errors could aggregate and cause a correctable error to become an uncorrectable error. Thus, use of EEA and requesting the directed scrub operation via the memory management command helps to reduce the likelihood of an uncorrectable error occurring. The data integrity of the memory system is improved, and uncorrectable errors significantly reduced.

In one embodiment, a non-volatile RAM implements a maintenance mode (MM) command for scrubbing as a memory-embedded management approach to control RBER increase through a scrub operation (to fix existing errors). The scrub may be performed after a read operation where the read data is corrected by sending a maintenance mode command from an external controller to a memory device (e.g., one or more memory chips). The MM command is encoded to initiate a directed scrub of a specific row of the non-volatile RAM.

In one embodiment, a memory system includes a memory array on a memory die and an external controller. The controller performs a read operation to read data stored in a row of the memory array. An ECC engine on the memory die determines that at least one error exists in the read data and sends at least one signal to the controller. In response to the signal(s), the controller issues a MM command to cause a scrubbing operation on at least a portion of the row just accessed during the read operation.

In an alternative embodiment, the scrub can be performed as a periodic scrub of a row as determined by an intemal row address pointer (e.g., an ECS counter or scrub counter on a memory die). A memory controller can issue periodic scrub commands. Upon receiving a periodic scrub command from the memory controller, a memory device performs a scrub to the code words pointed to by the row address pointer. After the scrub occurs, the row address pointer may be updated to point to the next set of code words to be scrubbed. In one embodiment, the command options for directed scrub and periodic scrub are available by an external controller in addition to options of periodic maintenance (without error correction) and/or activity-based memory management.

In one embodiment, an external or intemal controller triggers, based on a timer, a scrubbing operation for at least one address in a memory. The controller performs the scrubbing operation by correcting data stored at the address.

In one embodiment during scrubbing, a code word ECC engine is used to detect and correct errors on a given code word (e.g., stored in an activated row of a memory array). The code word consists of data and parity to be processed by the code word ECC engine. A scrub by the code word ECC engine can be triggered by an activity-based or other memory management operation.

In one embodiment, a memory device uses a counter to count memory management commands. The counter tracks the number of issued activity-based memory management (MM) commands. In one example, a scrub is performed when the counter reaches a threshold, then the counter is reset. In one embodiment, the threshold at which a scrub is performed may be randomized. This can help improve security of the memory device.

Various advantages can be provided by at least some embodiments described herein. For example, the use of a MM command for directed or periodic scrub provides faster and lower power memory management (e.g., to keep RBER under a level so that read operations are performed with no errors, or a number of errors correctable by an internal ECC engine).

For example, an external memory controller can trigger, upon need, a scrub operation using circuitry and/or firmware that is embedded in the memory device. The scrub operation is performed through an optimized MM command. This saves time and power because there is no data exchange between the external memory controller and the memory device to perform the write back of the corrected data.

In one example, the directed and periodic scrub approaches can be implemented with full compatibility with existing protocols/commands. The directed and periodic scrub capabilities may be exposed through a mode register, and both may be made available as features together or as a single feature according to memory device implementation and system requirements.

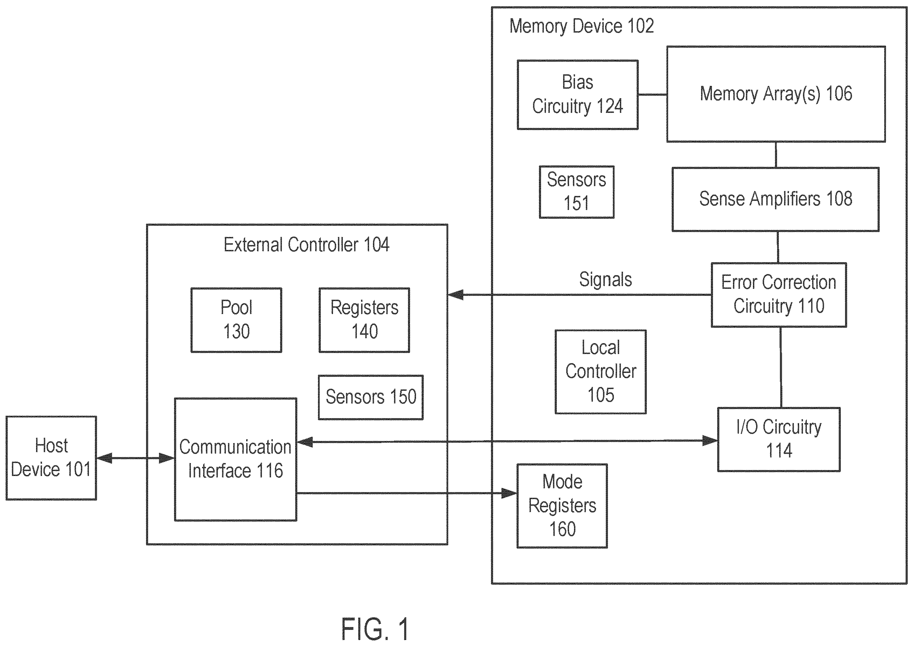

**FIG. 1** shows a memory device 102 that performs memory management operations on one or more memory arrays 106 in response to commands received from an external controller 104, in accordance with some embodiments. Controller 104 selects the commands to send based on signals received from error correction circuitry 110 of the memory device 102. In one example, memory management operations selected by external controller 104 can include various types of scrubbing (e.g., directed, periodic, activity-based), and/or wear leveling for a pool 130 (e.g., a pool with pointers pointing to memory locations in memory arrays 106).

More generally, wear leveling for pool 130 (e.g., a pool with pointers pointing to memory locations in memory arrays 106) may exist in either external controller 104 or local controller 105. The wear leveling operations may be performed by external controller 104 or by local controller 105 (e.g., logic circuitry) of memory device 102.

In the event that wear leveling operations are performed by the external controller, the wear leveling pointers are updated and maintained by the external controller. After a certain number of activates or after a certain amount of time has elapsed, the external controller may use activate, read, write, and precharge commands to perform wear leveling cycles. In this case, wear leveling is managed by the external controller. This may be advantageous in some situations as the external controller has full control and awareness of the wear leveling algorithm.

In the event that wear leveling operations are performed by the local controller of the memory device, the wear leveling pointers are updated and maintained within the memory device. After a certain number of activates or after a certain amount of time of time has elapsed, the external controller may issue a memory management command. Upon the memory device receiving a memory management command, the memory device may trigger a wear leveling operation. The wear leveling operation may result in activate, read, write, and precharge operation being internally issued within the memory device to perform wear leveling cycles. In this case, wear leveling is managed by the memory device. This may be advantageous in some situations as the overhead and responsibility attributed to the external controller is reduced.

User data is stored in one or more memory arrays 106. Bias circuitry 124 (e.g., one or more wordline drivers) applies voltages to access lines of memory arrays 106. In one example, bias circuitry 124 activates a word line in memory array 106.

In one embodiment, memory device 102 includes one or more memory dies. Each memory die includes one or more memory arrays 106. Memory device 102 is managed by external controller 104. Memory device 102 includes a local controller 105 that communicates with external controller 104.

In one embodiment, a memory module (e.g., components mounted on a circuit board and/or encapsulated in a package) includes external controller 104 and one or more memory devices 102. In one example, the memory module contains an external controller and a multiplicity of memory devices (e.g., memory components, memory dies, etc.). One or more of the memory devices may be controlled by the external controller.

In one embodiment, memory device 102 is a memory die (e.g., a memory component of a CXL memory module), and external controller 104 (e.g., an ASIC or CXL controller) sends various commands to a local controller 105 on the memory die to control various memory die operations (e.g., activate, read, write, precharge, refresh, memory management, etc.) upon receiving appropriate commands from the external controller 104.

The external controller 104 and the memory die exist on separate integrated circuits. External controller 104 may control a multiplicity of memory dies. In such case, each memory die can have its own local controller 105 that communicates with external controller 104.

In one example, host device 101 communicates with external controller 104 using a PCle interface. External controller 104 is a COMPUTE EXPRESS LINK (CXL) controller managing multiple channels (0 to n) of memory storage. Each channel is implemented by multiple memory components interfaced with the CXL controller. Each memory component can be configured as a memory device 102. The CXL controller receives signals from error correction circuitry 110 of each memory component. Based on these signals, the CXL controller issues memory management commands to one or more of the memory components. The memory management commands can be received from the CXL controller by a local controller 105 of each memory component.

In one embodiment, the type of scrubbing operation is selected by external controller 104 based on a context of the memory device 102. In one embodiment, data is received by external controller 104 from one or more sensors 150, 151 and used in determining the context. In one example, a sensor 150 and/or 151 provides temperature data. In one example, the temperature data corresponds to a temperature of memory array 106 and/or memory device 102.

In some embodiments, wear leveling pointers pointing to memory locations in memory arrays 106 may exist within an ASIC controller (e.g., external controller 104). Therefore, the ASIC controller can perform wear leveling operations by issuing read and write commands to memory device 102. This approach can be extended beyond wear leveling to memory management operations in general. By this extended approach, the ASIC controller can perform memory management operations by issuing read and write commands to memory device 102.

In other embodiments, the wear leveling pointers pointing to memory locations in memory arrays 106 may exist within memory device 102. Therefore, memory device 102 can perform wear leveling operations upon receiving a memory management command from the ASIC controller. This can be extended beyond wear leveling to memory management operations in general. By this general approach, memory device 102 can perform memory management operations upon receiving a memory management command from the ASIC controller (e.g., the operation to perform is defined by configuration bits associated with the command).

In one example, pool 130 is used as described for **FIG.** 1 (e.g., pool 130 includes wear leveling pointers pointing to memory locations in memory arrays 106). Pool 130 can exist in either the external controller or the memory device.

Read and write requests may be sent from host device 101 to external controller 104. External controller 104 may then process these requests and issue read and write commands to memory device 102.

In one embodiment, memory device 102 includes mode registers 160, which are used to configure one or more memory management operations. Mode registers 160 are accessible to hostdevice 101 (e.g., via communication interface 116 of external controller 104). Host device 101 can store bits of data in mode registers 160 to configure the memory management. In one example, local controller 105 selects the type of memory management operation to perform on memory array 106 based on configuration data stored in mode register 160.

In another embodiment, the external controller selects a memory management operation attributed to the memory management command by adjusting mode register options independent of the host device.

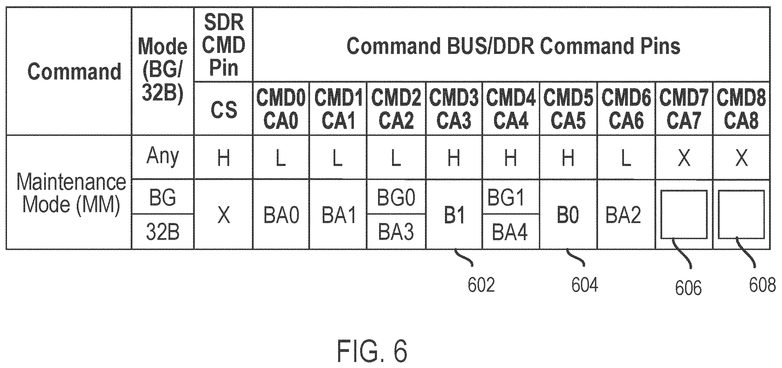

In one embodiment, Mode Register Write (MRW) commands are used to write values to mode registers (e.g., 160) that exist on the memory device. Therefore, the type of memory management operation triggered by the memory management command may be selected by one of the following approaches: (i) bits that exist on the memory management command (e.g., as shown in **FIG. 6****),** or (ii) bits that exist on a mode register.

In some embodiments, one or the other approach above can be used. However, in other embodiments both approaches may be used at the same time. For example, B1 and B2 may exist on the memory management command (as shown in **FIG. 6****)** and B3 and B4 may exist on a mode register. The mode register approach may be used when there is a shortage of available bits that can be communicated on the memory management command.

In one example, mode registers 160 are configured to expose the capability of directed and/or periodic scrubbing to external controller 104 and/or host device 101. The external controller 104 or host device 101 reads mode registers 160 to detect that these capabilities exist.

In some embodiments, the configurations as indicated by command address bits 602, 604 of the table in FIG. 6 can instead be partially or fully implemented using mode registers 160. In one embodiment, a local controller 105 existing within a memory component (e.g., a local controller on the same die as a memory array(s) managed by the local controller) uses data stored in mode registers 160 to determine the type of scrub to enable and/or perform. The local controller 105 receives commands from external controller 104 (e.g., ASIC controller). In one embodiment, configuration bits can be written by host device 101 to the mode registers before a maintenance mode command is issued. In this manner, data stored in mode registers 160 specifies the type of command to be used.

In one embodiment, memory arrays 106 are configured in one or more memory dies managed by external controller 104. The memory dies store user data for host device 101. The latency of a row access (e.g., performed in response to a request for user data from host device 101) consists of three activities: opening a row (e.g., ACTIVATE), accessing the data (e.g., READ or WRITE), and closing the row (e.g., PRECHARGE).

When a read operation is successful, ECC correction may have been applied by error correction circuitry 110 to correct an error. In some cases, no error is corrected. In one example, a memory die (e.g., memory device 102) sends ECC error alert (EEA) bits on a DMI signal along with the read data on a DQ bus (or a different pin according to device specification) to notify the external controller 104 whether ECC correction has been applied (including an indication of the type of correction).

The external controller 104 receives the ECC error alert bits. In the case where embedded ECC correction has been applied, controller 104 determines whether to scrub the row being accessed in the read operation. In one embodiment, external controller 104 compares signals received from error correction circuitry 110 to an error threshold. In one example, the threshold is a number of bit errors. If the signal or signals indicates a number of bit errors that equals or exceeds the threshold, controller 104 issues a command to the corresponding memory die (e.g., external controller 104 sends a command to local controller 105) to request a scrub of the row just accessed. The error threshold at which a row is scrubbed is selectable by the controller 104 based on the margin desired with respect to the correction power of the error correction circuitry 110 (e.g., intemal ECC engine of the memory die).

In this case, the external controller 104 issues the MM command with an option that performs the scrub of the row address previously accessed. This is referred to herein as a directed scrub.

The type of MM command to be performed is selectable based on encoding information provided with the MM command to the corresponding memory die. In one example, the MM command option is selected through two dedicated command address (CA) bits. In one example, the encoding for these two bits is as follows: 00b Periodic MM, 10b Activity-Based MM, 01b Directed SCRUB, 11b Periodic SCRUB.

The MM command is bank-based and, for example, if the option bits are 01b, the SCRUB is performed on the last accessed row (e.g., the row just accessed in the immediately preceding read operation) of that bank. The MM command for a directed SCRUB is issued before any other ACTIVATE command on the same bank. Otherwise, the row address information will be lost, and the maintenance operation is no longer performed on the row last accessed.

When the directed scrub is performed, there is no data transfer required between the external controller 104 and the memory die. The scrub is managed internally to the memory die (e.g., memory device 102) through a sequence including the following operations: ACTIVATE, READ, ECC correction, WRITE, PRECHARGE. This sequence is initiated by sending the memory management command to the memory die with command encoding indicating selection of a directed scrub operation.

In one embodiment, external controller 104 issues the MM command with encoding to select an option (e.g., the two encoding bits are 11b) to scrub the memory periodically at the address stored in an intemal row address counter (not shown). The scrub is performed at this address regardless of any signals from error correction circuitry 110. This is an example of a periodic scrub.

The directed and/or periodic scrub can be configured to operate on one or more columns of a row, on the entire row, or on multiple rows, according to the desired device implementation.

In one example, controller 104 implements wear leveling management using pool 130 and registers 140. Pool 130 corresponds to a set of memory locations in memory array 106 that are managed using a start-gap algorithm. In one embodiment, pool 130 includes memory to store data (e.g., start location, gap location spacings or offsets, size) regarding a pool of memory cells of memory array 106 to which scrubbing and/or wear leveling is applied. Registers 140 store a pointer to a start location of pool 130 and store one or more pointers to gap locations. In one embodiment, controller 104 uses data stored in registers 140 and/or pool 130 for determining physical address locations in the pool based on logical addresses received from host device 101.

In one case, pointers and a wear leveling pool are managed by the external controller. Wear leveling movements are performed by the external controller through issuing activate, read, write, and precharge commands. In another case, wear leveling is managed from within the memory device. For example, pool 130 and registers 140 are used and exist within memory device 102.

In one example, controller 104 implements a wear leveling manager. Controller 104 is, for example, a memory controller for a CXL memory module. Memory arrays 106 are, for example, a non-volatile RAM memory array.

In one embodiment, error correction circuitry 110 services memory management operations performed on data stored in memory array(s) 106. Portions of data from memory array 106 are copied to a temporary storage (e.g., buffer) during servicing (e.g., scrubbing, wear leveling). In one example, the temporary storage includes holding registers. In one example, error correction circuitry 110 includes a scrub ECC engine.

Error correction circuitry 110 services read and write operations. For example, the read or write operations are performed in response to commands or other signals received by the memory device 102 from the external controller 104. Examples of commands include a directed scrub command or a periodic scrub command.

External controller 104 causes local controller 105 to access portions of memory array(s) 106 in response to commands received from host device 101 via communication interface 116. Sense amplifiers 108 sense data stored in memory cells of memory arrays 106. Local controller 105 accesses the stored data by activating one or more rows of memory arrays 106. In one example, the activated rows correspond to a page of stored data. In one example, local controller 105 receives a memory management command from external controller 104.

When a row of memory array 106 is activated, data can be read from the row as part of a read or other operation (e.g., scrubbing, wear leveling). Error correction circuitry 110 is used to detect and correct any errors identified in the accessed data on the row (e.g., for a read requested by host device 101). Corrected read data is provided for output on communication interface 116 by I/O circuitry 114. In one example, external controller 104 communicates with I/O circuitry 114 using a command bus (CA BUS), a data bus (DATA BUS), and DMI signals.

In one embodiment, communication interface (I/F) 116 is a bi-directional parallel or serial communication interface. The host device 101 can include a host processor (e.g., a host central processing unit (CPU) or other processor or processing circuitry, such as a memory management unit (MMU), interface circuitry, etc.).

In one embodiment, memory arrays 106 can be configured in a number of non-volatile memory devices (e.g., dies or LUNs), such as one or more stacked flash memory devices each including non-volatile memory (NVM) having one or more groups of non-volatile memory cells and a local controller 105 or other periphery circuitry thereon (e.g., device logic, etc.), and controlled by external controller 104 over an intemal storage-system communication interface (e.g., an Open NAND Flash Interface (ONFI) bus, etc.) separate from the communication interface 116.

In one embodiment, each memory cell in a NOR, NAND, 3D cross point, MRAM, or one or more other architecture semiconductor memory array 106 can be programmed individually or collectively to one or a number of programmed states. A single-level cell (SLC) can represent one bit of data per cell in one of two programmed states (e.g., 1 or 0). A multi-level cell (MLC) can represent two or more bits of data per cell in a number of programmed states (e.g., 2ⁿ, where n is the number of bits of data). In certain examples, MLC can refer to a memory cell that can store two bits of data in one of 4 programmed states. A triple-level cell (TLC) can represent three bits of data per cell in one of 8 programmed states. A quad-level cell (QLC) can represent four bits of data per cell in one of 16 programmed states. In other examples, MLC can refer to any memory cell that can store more than one bit of data per cell, including TLC and QLC, etc.

The external controller 104 can receive instructions from the host device 101, and can cause local controller 105 to transfer data to (e.g., write or erase) or from (e.g., read) one or more of the memory cells of the memory arrays 106. The controller 104 or 105 can include, among other things, circuitry or firmware, such as a number of components or integrated circuits. For example, the controller 104 or 105 can include one or more memory control units, circuits, or components configured to control access across the memory array and to provide a translation layer between the host device 101 and a storage system, such as a memory manager, one or more memory management tables, etc.

In one embodiment, controller 104 or 105 can include circuitry or firmware, such as a number of components or integrated circuits associated with various memory management functions, including, among other functions, wear leveling, error detection or correction, bank or block retirement, or one or more other memory management functions.

In one embodiment, controller 104 or 105 can include a set of management tables configured to maintain various information associated with one or more components of memory device 102 (e.g., various information associated with pool 130, memory array 106, and/or one or more memory cells coupled to controller 105). For example, the management tables can include information regarding bank or block age, block erase count, error history, or one or more error counts (e.g., a write operation error count, a read bit error count, a read operation error count, an erase error count, etc.) for one or more banks or blocks of memory cells coupled to the controller 105. In certain examples, if the number of detected errors for one or more of the error counts is above a threshold, the bit error can be referred to as an uncorrectable bit error. The management tables can maintain a count of correctable or uncorrectable bit errors, among other things.

In one embodiment, memory device 102 can include one or more three-dimensional (e.g., 3D NAND) architecture semiconductor memory arrays 106. The memory arrays 106 can include a number of memory cells arranged in, for example, banks, a number of devices, planes, blocks, physical pages, super blocks, or super pages. As one example, a TLC memory device can include 18,592 bytes (B) of data per page, 1536 pages per block, 548 blocks per plane, and 4 planes per device.

In one embodiment, data can be written to or read from the memory device 102 in pages. However, one or more memory operations (e.g., read, write, erase, etc.) can be performed on larger or smaller groups of memory cells, as desired. For example, a partial update of tagged data from an offload unit can be collected during data migration or garbage collection to ensure it was re-written efficiently.

In one example, a page of data includes a number of bytes of user data (e.g., a data payload) and its corresponding metadata. As an example, a page of data may include 4 kB of user data as well as a number of bytes (e.g., 32B, 54B, 224B, etc.) of auxiliary or metadata corresponding to the user data, such as integrity data (e.g., error detecting or correcting code data), address data (e.g., logical address data, etc.), or other metadata associated with the user data. Different types of memory cells or memory arrays can provide for different page sizes or may require different amounts of metadata associated therewith.

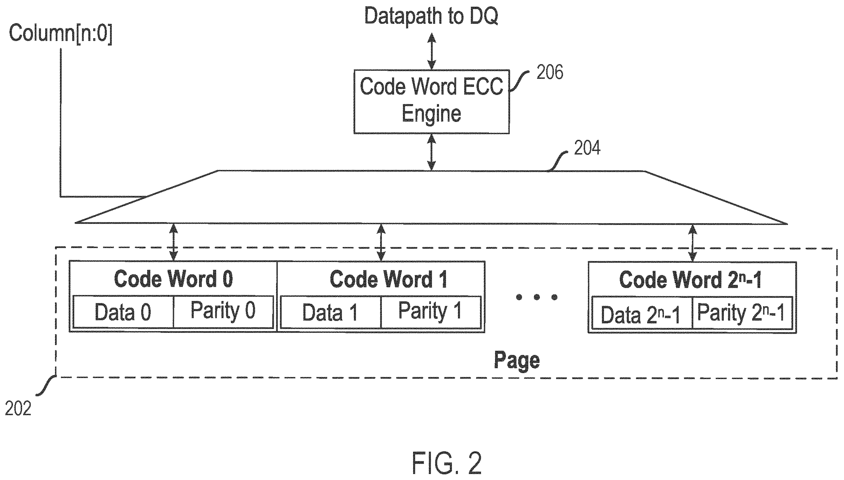

**FIG. 2** shows a code word ECC engine 206 used to correct errors for data stored in pages in a memory array, in accordance with some embodiments. Code word ECC engine 206 is an example of error correction circuitry 110 and services data for a read and write data path of a memory device.

In one example, a page 202 is accessed by activating a row in memory array 106. The error in the accessed page is detected using code word ECC engine 206. In one example, page 202 contains multiple code words 0, 1, ... 2ⁿ-1. In one embodiment, data stored in the code words of page 202 includes both user data and parity data stored for each code word.

Each page 202 in the memory array has multiple columns [n:0]. Data being read from or written to page 202 is addressed by a row address and a column address. The row address corresponds to a word line that is activated to access data stored in page 202. The column address is used by column decoder 204 to select a column for memory cells containing the data to be accessed.

During a read operation, data read from page 202 is processed by code word ECC engine 206 to detect and correct errors. Corrected data is, for example, communicated to a host device via a data path to input/output pins (e.g., DQ pins).

In one embodiment, each code word of page 202 includes user data (e.g., Data 0) and a parity (e.g., Parity 0) previously calculated for that data. In one example, the parity is an error correction code providing a capability to correct one or more bits of the code word. The parity stored for each code word can be computed by ECC engine 206 when the code word is stored. ECC engine 206 can use the parity stored for each code word to detect and correct one or more bit errors of the code word when the code word is being read.

In one example, when an activate command is issued, page 202 is sensed, and the data for the page is stored in sense amplifier latches.

In one example, a memory management operation is allocated to scrub the page 202. The scrub uses error correction circuitry (e.g., 110) where each code word is scrubbed one at a time (e.g., the corrected data is written back into a holding register one code word at a time).

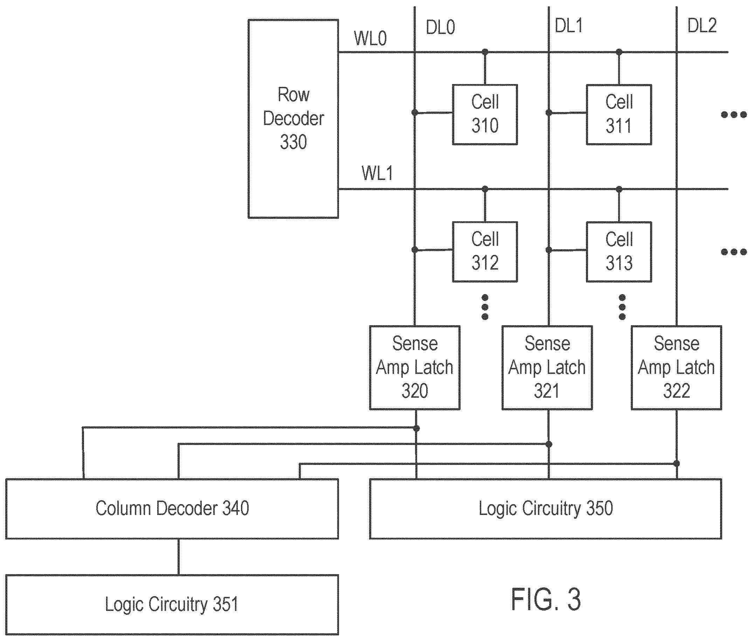

**FIG. 3** shows sense amplifier latches 320, 321, 322 to hold data associated with memory cells 310, 311, 312, 313 of a memory array, in accordance with some embodiments. In one example, the memory cells are located in memory array 106. The memory cells can be of various memory types including volatile and/or non-volatile memory cells.

The memory cells are accessed using word lines (e.g., WL0) and digit lines (e.g., DL0) or bit lines. An individual memory cell is accessed by activating a word line selected by row decoder 330 and selecting a digit line or bit line selected by column decoder 340. When a word line is activated, data from each memory cell on a row resides in the corresponding sense amplifier latch for each digit line or bit line.

Data residing in the sense amplifier latches can be used as inputs to logic circuitry 350, 351 for various computations. These can include using parity or other metadata stored with the memory cells to detect and/or correct errors in the data retrieved from the memory cells. In one embodiment, logic circuitry 350 includes error correction circuitry. In one example, logic circuitry 350 is arbitrary logic that operates on data at the page level.

Logic circuitry 351 is coupled to column decoder 340. In one embodiment, logic circuitry includes error correction circuitry 110. In one example, logic circuitry 351 is arbitrary logic that operates on data at the column (e.g., code word) level (e.g., ECC engine 206).

In one embodiment, a memory device including a memory array has a plurality of memory cells 310, 311, 312, 313, etc., and one or more circuits or components to provide communication with, or perform one or more memory operations on, the memory array. A single memory array or additional memory arrays, dies, or LUNs can be used. The memory device can include row decoder 330, column decoder 340, sense amplifiers, a page buffer, a selector, an input/output (I/O) circuit, and a controller.

In some non-volatile memory devices (e.g., NAND flash), the memory cells of the memory array can be arranged in blocks. Each block can include sub-blocks. Each sub-block can include a number of physical pages, each page including a number of memory cells. In some examples, the memory cells can be arranged in a number of rows, columns, pages, sub-blocks, blocks, etc., and accessed using, for example, access lines, data lines, or one or more select gates, source lines, etc.

In volatile memory devices (e.g., DRAM) and some emerging non-volatile memory technologies, the memory cells of the memory array can be arranged in banks or other forms of partition. In one example, when an activate to a row address is issued, the row address may be addressed by addressing bits on the activate command using a bank address (to specify which bank within the memory device), and a row address (to specify which row within the specified bank). The word line associated with the row address is brought high.

A controller (e.g., controller 104) can control memory operations of the memory device according to one or more signals or instructions received on control lines (e.g., from host device 101) including, for example, one or more clock signals or control signals that indicate a desired operation (e.g., write, read, erase, etc.), or address signals (A0-AX) received on one or more address lines. One or more devices external to the memory device can control the values of the control signals on the control lines, or the address signals on the address line. Examples of devices external to the memory device can include, but are not limited to, a host, a memory controller, a processor, or one or more circuits or components.

The memory device can use access lines and data lines to transfer data to (e.g., write or erase) or from (e.g., read) one or more of the memory cells. The row decoder and the column decoder can receive and decode the address signals (A0-AX) from the address line, can determine which of the memory cells are to be accessed, and can provide signals to one or more of the access lines (e.g., one or more of a plurality of word lines (e.g., WL0-WLm)) or the data lines (e.g., one or more of a plurality of bit lines (BL0-BLn).

The memory device can include sense circuitry, such as sense amplifiers 108, configured to determine the values of data on (e.g., read), or to determine the values of data to be written to, the memory cells using the data lines. In one example, sense amplifiers are used to sense voltage (e.g., in the case of charge sharing in DRAM). In one example, in selected memory cells, one or more of the sense amplifiers can read a logic level in the selected memory cell in response to a read current flowing in the memory array through the selected cell(s) to the data line(s).

One or more devices external to the memory device can communicate with the memory device using I/O lines (e.g., DQ0-DQN), address lines (e.g., A0-AX), or control lines. I/O circuitry (e.g., 114) can transfer values of data in or out of the memory device, such as in or out of the page buffer or the memory array, using the I/O lines, according to, for example, the control lines and address lines. The page buffercan store data received from the one or more devices external to the memory device before the data is programmed into relevant portions of the memory array, or can store data read from the memory array before the data is transmitted to the one or more devices external to the memory device.

The column decoder 340 can receive and decode address signals (e.g., A0-AX) into one or more column select signals (e.g., CSEL1-CSELn). The selector (e.g., a select circuit) can receive the column select signals (CSEL1-CSELn) and select data in the page buffer representing values of data to be read from or to be programmed into memory cells. Selected data can be transferred between the page buffer and the I/O circuitry.

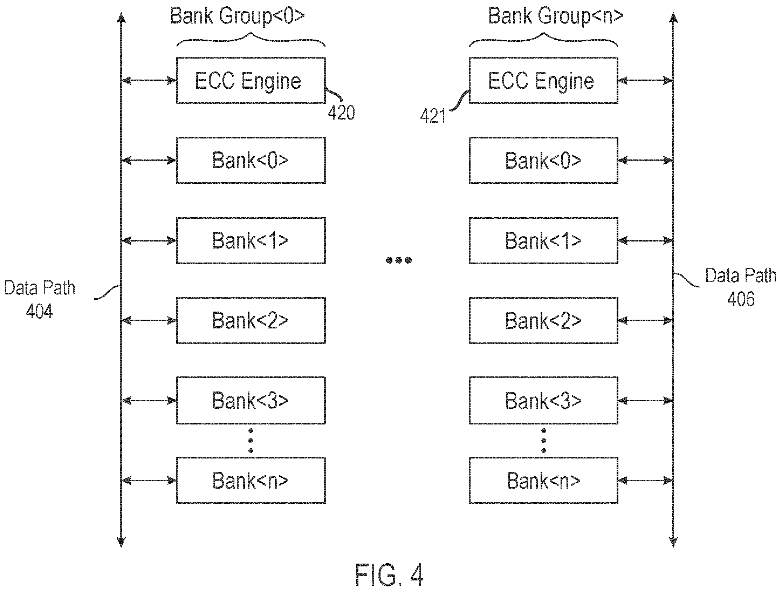

**FIG. 4** shows a data path 404, 406 for read and write operations for a host device (e.g., 101) for each of multiple banks in a memory device, in accordance with some embodiments. The banks can be arranged in bank groups (e.g., any number "n" of bank groups as indicated by "Bank Group <n>").

Data path 404, 406 is an example of a data path including I/O circuitry 114 and communication interface 116. In one embodiment, each bank group has a respective associated ECC engine 420, 421. ECC engines 420, 421 service read and write operations on data paths 404, 406. ECC engines 420, 421 are an example of error correction circuitry 110.

In one embodiment, ECC engines 420, 421 service memory management operations such, for example, as directed and periodic scrubbing of data in one or more banks.

In some embodiments, to reduce total scrub time, there may be multiple ECC engines that exist on the memory device to allow multiple banks to be scrubbed in parallel. For example, a memory device may contain four bank groups and four ECC engines. In this case, each bank group is associated with its own ECC engine. A memory management group may contain subset of banks that may exist across one or more bank groups.

In one example, each page of a bank consists of code words or columns. A memory management command has been issued to a particular bank. The page is the set of specific memory cells that are activated when an activate command is issued. An activate command has a bank address as well as a row address.

In one embodiment, each bank group is coupled to a particular data path for that bank group. In one example, a data path is 100 bits wide.

In one example, a particular memory die may have many memory management groups. A memory management command is issued to a specific memory management group. This causes a memory management operation to occur for all banks in the group. The group is coupled to an ECC engine(s). A local controller (e.g., 105) iterates through each bank in the group. In one example, the standard data bus for a memory device is a bi-directional bus.

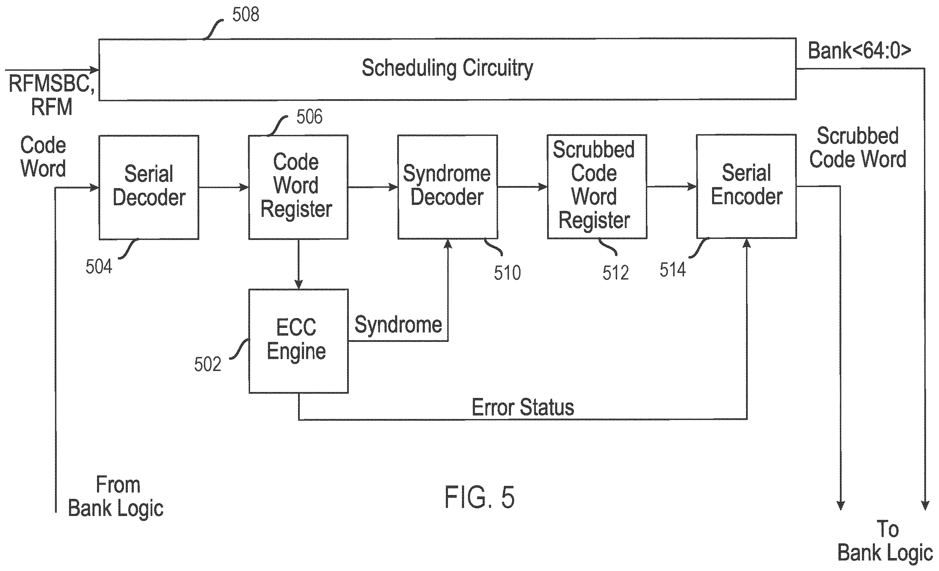

**FIG. 5** shows error correction circuitry (e.g., error correction circuitry 110) for scrubbing code words from a bank of a memory array, in accordance with some embodiments. In one example, the code words are received from a bank of a bank group as illustrated in **FIG. 4****.**

The dedicated error correction circuitry of **FIG. 5** is used by a memory component (e.g., memory device 102) to service scrubs during memory management operations (e.g., scrub ECC engine mentioned above). To minimize die area, this dedicated error correction circuitry can be connected to the banks with a narrower data bus than used for the code word ECC engine. This is a motivation for using the serial encoder/decoder 504, 514. This dedicated error correction circuitry for memory management operations is preferred when not every bank is associated with a unique code word ECC engine.

If the code word ECC engine exists for every bank, then the code word ECC engine may also service scrubs during memory management operations (e.g., code word ECC engine is equivalent to a scrub ECC engine). If every bank on a memory die is not associated with a code word ECC engine, then a multiplicity of scrub ECC engines can be used to service scrubs during memory management operations (e.g., scrub during wear leveling, directed scrub, periodic scrub, activity-based scrub, etc.).

The code word ECC engine (e.g., 206 of **FIG.** 2) typically would only use code word register 506, ECC engine 502, and syndrome decoder 510 from **FIG.** 5. The serial encoder/decoder would not be required because the data bus (e.g., 406) connecting the code word ECC engine and the memory bank would be the width of a full code word.

Scheduling circuitry 508 receives signals from a controller (e.g., 104 or 105). One of the signals is a memory managementcommand (e.g., RFM). Anothersignal is a signal that indicates a grouping of banks and/or bank groups to use for memory management operations. Another signal is a signal provided from a mode register setting (e.g., data from mode registers 160) that sets the granularity of the memory management group or bank size (e.g., RFMSBC). Scheduling circuitry 508 sends signals to logic circuitry of one or more banks to control transfer of code words from each bank to serial decoder 504.

In one example, eight banks are run in parallel for wear leveling. The scrub time of one bank is proportional to the bus width of the scrub ECC engine that services the bank.

In one embodiment, serial decoder 504 receives one code word at a time from each bank. The code word is decoded by serial decoder 504 and stored in code word register 506. ECC engine 502 generates a syndrome for the code word as an output. The syndrome is decoded by syndrome decoder 510, and a scrubbed code word is provided as output and stored in register 512. The scrubbed code word is encoded by serial encoder 514 and transferred back to the bank that sent the code word.

When performing error detection and/or correction on each code word, ECC engine 502 generates various signals (illustrated as "Error Status") indicating a state or status from processing the code word. In one example, the signals (e.g., EEA bits) are provided to controller 104 and used in selecting and/or configuring memory management operations (e.g., directed and/or periodic scrubbing).

In some embodiments, a code word ECC engine (e.g., 206) generates EEA bits during read commands.

In one embodiment, the signal is an uncorrectable error alert that indicates the code word contains one or more uncorrectable errors. One or more of these signals are provided to serial encoder514, which encodes the signals for sending to the bank to which the code word is returned. The signal can be used by a controller to modify operations of the memory device.

In one embodiment, transmission of the scrubbed code word to the bank logic and transmission of the next code word from the bank logic may occur simultaneously.

In one embodiment, the memory device is nonvolatile, but the holding registers are volatile (e.g., CMOS) registers. If power is lost while scrub is occurring in the background, data can be lost if not already transferred to the target row. The write data might be in the volatile source holding register. In one example, if power is detected as being lost, a controller uses available capacitance to transfer the data.

In one embodiment, bank logic or a local controller performs a wear leveling soft repair based on a signal from the scrub ECC engine. This mitigates the risk of the accumulation of uncorrectable errors throughout the entire array.

An uncorrectable physical defect (e.g., 4 or 5 bits stuck low), cannot be corrected because the number of errors exceeds the correction capabilities of the ECC engine. Thus, in the event of an uncorrectable error, the ECC engine detects that there is an uncorrectable error, but does not attempt to correct the data. In this case, the data remains unchanged with the uncorrectable error still existing in the holding register.

For example, if there is a source page that is uncorrectable (e.g., 4 or 5 bits stuck high or low), because all data in a wear leveling pool ultimately moves through any given page, it could eventually corrupt all data in the wear leveling pool. To reduce this risk, a wear leveling soft repair occurs.

Scrubbing correctable errors during wear leveling prevents the accumulation correctable errors that could aggregate into an uncorrectable error (e.g., as described above). However, a wear leveling soft repair can be used to mitigate the risk of an uncorrectable defect corrupting the entire wear leveling pool (e.g., as described below).

In one example, the scrub ECC engine detects that there is an uncorrectable error. The ECC engine can identify that there is uncorrectable data in the source row. Within the memory management cycle, the ECC engine automatically performs a soft repair. Wear leveling movement cycles are moved away from the defective source row. The scrub ECC engine sends an indication of an uncorrectable error back to the bank logic and an automatic soft repair can be done to the source row. This allows wear leveling movements to be diverted from the physically bad row.

In one embodiment, scrub ECC circuitry uses two uni-directional buses for connecting to the appropriate banks. Code words are transmitted on a data bus and this information is decoded using the serial decoder. A code word register is populated. A scrub ECC engine computes parity and compares the computed parity to the stored parity to produce a syndrome. A syndrome decode occurs which may cause some bits to flip to correct the code word.

The error status signal(s) generated by ECC engine 502 may consist, for example, of the following cases for which data can be communicated to the bank logic:
- [Case 1] No errors
- [Case 2] Error detected and corrected
- [Case 3] Two errors detected and corrected
- [Case 4] Uncorrectable error

It should be noted that this pattern can be reduced or extended to cover an ECC engine of any error detection and correction capability.

For the case of an uncorrectable error (e.g., case 4), the ECC engine is unable to provide any correction. Thus, the uncorrectable error cannot be corrected (e.g., scrubbed). In this case, the ECC engine may decide to send the same data it received back to the bank logic. Alternatively, the ECC engine may not send any data to the bank logic due to the scrub register requiring no update. Whether or not the ECC engine sends the uncorrected data back to the bank logic, the ECC engine may send the error status back to the bank logic.

When the bank logic receives the error status, some action may occur. For example, a wear leveling soft repair may occur. In some embodiments, a wear leveling soft repair may occur when a certain number of errors are detected. The exact number of errors (e.g., case 2, case 3, or case 4) is dependent upon process/yield capability.

In some examples, in addition to transmitting scrubbed source data to a bank, the ECC engine may also send additional information concerning any possible errors (e.g., no error, single-bit error, multiple-bit error, or uncorrectable error) to the local controller and/or to logic circuitry of the bank. Based upon the reception of this information, the bank or local controller may determine to perform an action such as performing an automatic repair to the source row in the background.

**FIG. 6** shows an example of a command address table for a maintenance mode command, in accordance with some embodiments. The type of maintenance mode command is selected using encoding bits (e.g., command address bits 602, 604) provided as part of the command. In one example, the encoding bits are used to specify a directed scrub command or a periodic scrub command.

In one example, additional encoding bits 606, 608 can be used to specify other types of maintenance mode commands and/or to configure a characteristic of performing the maintenance mode of operation.

Exemplary cases using 2-bits (602, 604) and 4-bits (602, 604, 606, 608) to specify how the memory management (MM) command is perceived by a local controller are described above. However, in general any number of bits can be used on the MM command to alter the function of the MM command.

In one example, the maintenance mode command is sent by the memory controller (e.g., ASIC controller) to a local controller and/or to logic circuitry on a memory die..

In some cases, activity-induced soft errors can be a problem for a memory device. The maintenance mode command is used to trigger different operations internally within the memory device to mitigate the different types of errors that might occur. In one example, the external controller (e.g., 104) knows the time available to perform a directed scrub or periodic scrub. The controller can determine the extent to which each scrub is performed based on the available time. For example, the controller can vary the number of code words and/or rows that are scrubbed for any given maintenance mode command.

In one embodiment, an external controller identifies a row requiring a scrub. This row identification is communicated to a memory die. The memory die then performs a read/modify/write operation using an internal ECC engine to scrub data at the indicated row location.

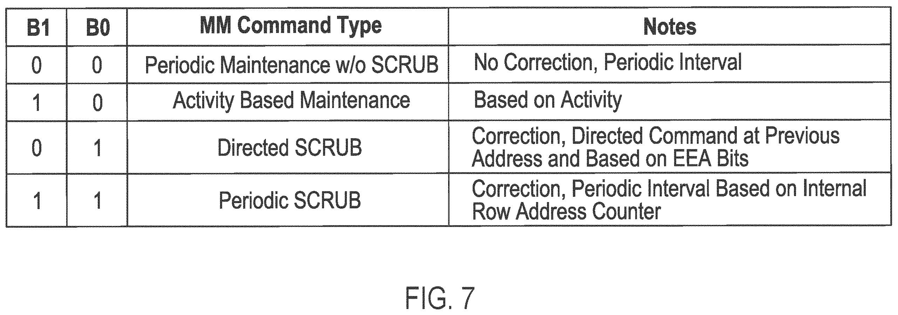

**FIG. 7** shows an example of selection of a maintenance mode command using command address bits, in accordance with some embodiments. Maintenance mode command types correspond to encoding bits B1, B0. In one example, the encoding bits are bits 602, 604.The command types that can be selected by an external controller (e.g., 104) include, for example, a periodic maintenance command without scrub, an activity-based maintenance command, a directed scrub, and/or a periodic scrub. The periodic maintenance is performed without data correction at a periodic interval (e.g., a fixed time period). In one example, the periodic maintenance includes sensing and flipping of data states in memory cells at a location in the memory array identified by the logic circuitry within a memory device (e.g., local controller 105).

In one example, a memory device performs a periodic MM operation when a MM command is issued with B1,B0 equal to 0,0 indicating "Periodic Maintenance w/o SCRUB" by the external controller. This periodic MM operation results in the memory device sensing and flipping the data states for memory cells at a location in the memory array identified by logic circuitry within the memory device (e.g., local controller 105). In one example, the location is identified by a "Sense & Flip Counter." This counter can be implemented similarly to a refresh counter, ECS counter, or periodic scrub counter in that the counter keeps track of what address space is to undergo some operation. Once the operation occurs, the counter is updated or incremented.

The activity-based maintenance is triggered based on activity. In one example, the activity-based maintenance is triggered based on a number of accesses to a memory array or a location in the memory array. In one example, the maintenance is wear leveling. In one example, the data can be scrubbed.

In one embodiment, the directed scrub performs error correction. The directed scrub can be requested by the external controller (e.g., 104) based on EEA bits and/or other context data for a memory device. The scrub is performed at the address in a memory bank most recently accessed (e.g., during a read operation for which the EEA bits are generated).

In one embodiment, the periodic scrub performs error correction. The periodic scrub can be requested by the external controller based on EEA bits and/or other context data for a memory device. The scrub is performed at the address in memory as indicated by an intemal address counter of the memory device. After the scrubbing is performed, the internal address counter is incremented.

In an alternative embodiment, an external or local controller determines the address at which a scrub is performed. In one example, the address is determined by random sampling of addresses issued to the memory device. In one example, the address is determined based on a context of the memory device. In one example, the external controller communicates the maintenance mode command and the corresponding address at which to perform the memory management operation to a memory die.

In one embodiment, a controller mitigates adverse effects from activity-induced soft errors. Specifically, as a particular address (e.g., aggressor) sees more activates, there is an increased likelihood that a soft error may occur at that address. The aggressor may either be identified by the external controller or by the local controller of the memory device. In response to being identified, a memory management command may be used to scrub the identified aggressor.

In one example, the periodic interval at which an external controller issues periodic scrub commands is a time period. In one example, the periodic interval is a number of accesses to memory.

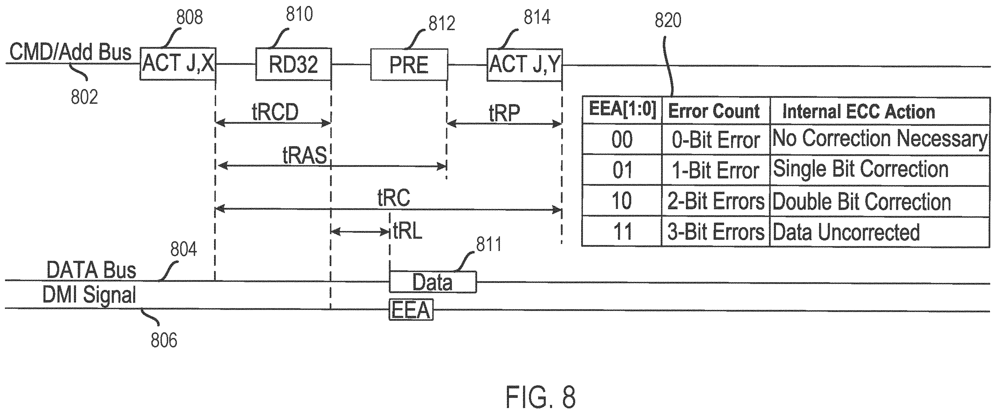

**FIG. 8** shows exemplary commands and timing used in a read operation. In one example, the read operation is performed in response to a request from a host device 101 for user data stored in memory array 106. In general, an external controller issues a read operation by issuing an activate command 808 to the memory device specifying a bank J and row X to be activated. The memory device then decodes the activate command, which ultimately results in an activate operation occurring at the appropriate address. This is also the case for memory management commands, read, write, and precharge commands. The command is issued to the memory device by the external controller. The memory device then decodes the command, which ultimately results in the appropriate operation occurring at the specified address.

Now referring again to **FIG. 8****,** the controller then issues a read command 810 (e.g., read 32) causing the reading of data 811 from the activated row. Next, the controller issues a precharge command 812 to close the row. After the row is closed, the controller can issue another activate command 814 specifying, for example, a different row Y in the same bank J. Time interval tRP is the minimum timing between PRECHARGE and ACTIVATE commands on the same Bank J.

The external controller sends the above commands on command bus 802. The read data 811 is returned from the memory on data bus 804. Signals (e.g., EEA bits) regarding error correction code processing of data 811 are provided on signal bus 806.

Table 820 illustrates exemplary EEA bits and corresponding error counts. In one example, an intemal ECC engine can make corrections of single or double-bit errors. Three-bit or greater errors are beyond the capability of correction. The error bits may vary in other embodiments according to the technology implemented and/or the particular data bus used in the memory device.

In one example, a Read Access of Bank J, Row X, is followed by the activation of Bank J, Row Y. The number of ECC Error Alert (EEA) bits provided from the Read Access is 2. The number of bits may vary according to device capability. The Scrub Threshold is equal to 1. This is a memory controller parameter that can be set according to the characteristics of the memory device. The controller compares the EEA bits to the Scrub Threshold to make decisions regarding future commands to issue (e.g., whether to issue a next activate command or to issue a directed scrub command, as described below).

In one embodiment, after a read latency tRL following the read command 810, data is sent on data bus 804. An external controller can determine to next do a directed scrub even if errors in the read data are zero. Instead, issuing the directed scrub can be based on other context conditions such as a temperature being above a threshold. The temperature can be determined, for example, by a sensor of the memory device or controller. If scrubbing is determined not to be performed, the controller can issue a new activate command 814 to that same bank to a different row after the prior row is closed by the prior precharge command 812.

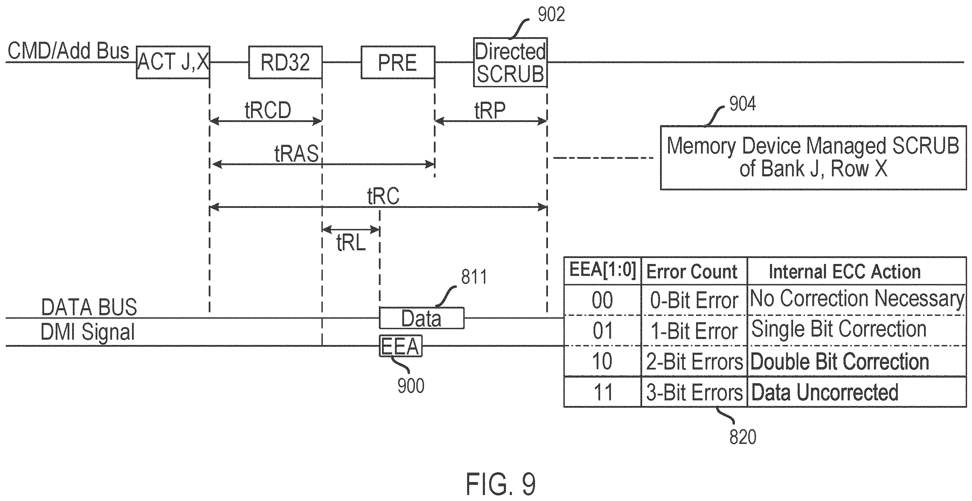

**FIG. 9** shows exemplary commands and timing for a directed scrub operation, in accordance with some embodiments. The commands and timing are similar to **FIG. 8****,** except that instead of the external controller issuing a next activate command, the external controller issues a directed scrub command 902. The directed scrub is selected based on comparing error status bits 900 to a scrub threshold. The status bits 900 are generated from error correction processing of read data 811.

In the illustrated example, the scrub threshold is one bit. The error status bits 900 indicate that a one bit error exists in data 811. Because the number of existing errors equals the scrub threshold, the controller issues directed scrub command 902. In some cases, it may be desired to fix the scrub threshold at a higher number of errors depending on the process, yield, and ECC correction characteristics of the memory device.

In general, the scrub threshold can be any criteria used by the controller to determine whether to issue a scrub command. For example, the scrub threshold may relate to a context of the memory device in addition to or other than errors in the read data.

In response to the directed scrub command 902, a memory device (e.g., memory die) internally performs a directed scrub sequence 904 of the same row or other address location that was most immediately previously accessed (the last row or address accessed in the read operation to obtain data 811). The directed scrub can be performed to scrub only the data (e.g., a portion of a row) that has just been read with the read command, or the entire row can be scrubbed even if only a portion of the row has been read.

In one example, a memory die including memory array 106 performs the complete directed scrub sequence 904 (e.g., activate, read, etc.) internally (e.g., using local controller 105). After issuing the directed scrub command, external controller 104 does not need to issue other commands to the memory die that are related to the directed scrub. The memory die performs the directed scrub sequence 904 in response to receiving the directed scrub command. No data transfer is required between the memory die and the controller 104. In one example, the memory die uses an intemal state machine to perform the internal operations for the directed scrub of activate, read, ECC correction, write, and precharge. Other banks can be accessed by the controller 104 during the directed scrub sequence 904.

In one example, internal ECC circuitry has corrected the data being read in a read operation for a bank, and the number of errors detected meets the SCRUB threshold. The memory controller (e.g., 104) determines that the row needs a directed scrub (e.g., after detecting 01b in the EEA bits 900, the controller issues a Directed SCRUB command after time tRP). The memory controller can issue a Directed SCRUB command (e.g., MM Command with 01b) before any other ACTIVATE command on the same bank. In response to the Directed SCRUB command, a memory device performs a complete ACTIVATE, READ, ECC correction, WRITE , PRECHARGE sequence (e.g., sequence 904). The directed scrub operation requires no data transfer between the memory controller and the memory device. This provides a saving in terms of time and power, and the directed scrub can be performed in parallel to operations on other banks.

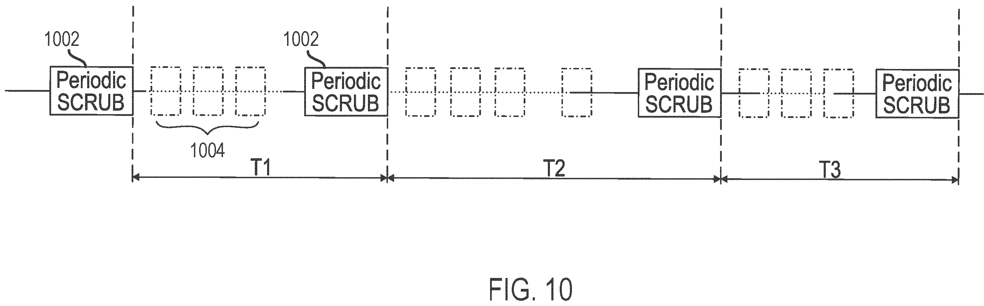

**FIG. 10** shows exemplary commands and timing for periodic scrub operations, in accordance with some embodiments. An external controller issues periodic scrub commands 1002 at periodic time intervals T1, T2, T3. For example, the periodic intervals T1, T2, T3 can be various selected time periods. Time periods T1, T2, T3 can be equal in duration or can be varied. In one example, the controller determines the periodic interval to use based on a context of a memory device. In one example, all of the addresses in the memory space are scrubbed sequentially in a round-robin manner.

Other commands 1004 can be issued by the controller in between issuance of periodic scrub commands 1002. Commands 1004 can include commands related to read or write operations. Commands 1004 can also include commands related to memory management operations other than the periodic scrub. In one example, commands 1004 include one or more directed scrub commands.

In one embodiment, the periodic SCRUB command allows a memory device to execute a scrub without requiring a previous READ operation that detects errors. The memory device internally stores the last row scrubbed and increments a row pointer after each periodic SCRUB command.

In one embodiment, the entire physical row is scrubbed. In some cases, the row scrubbing process may require more than one periodic scrub command. This can vary according to the number of columns in a row and/or vary with the memory device implementation.

In one embodiment, the periodic scrub command is used by the memory controller to maintain a number of errors (e.g., RBER for data read from the row and/or from a same portion of a memory that includes the row) under a fixed threshold and/or to execute a scrub on a selected bank that is receiving a lot of commands.

The Periodic SCRUB interval can be varied by the controller. For example, the frequency can be determined by an external memory controller. As for other maintenance commands, the bank on which maintenance is being performed is in an idle state during the maintenance.

The periodic scrub command can be sent for one bank and/or all banks in a memory die. Sending the periodic scrub command does not depend on any results from error correction. The ECC engine works on, for example, 128 bits at a time. So, portions of a row are scrubbed sequentially.

The periodic scrub command is not sent until a row of a first bank is closed. The first bank should not be active with any other accesses when the periodic scrub command is sent. Different commands can be sent by the controller to operate on one or more second banks while the periodic scrub is occurring on the first bank.

In general, the directed scrub and/or the periodic scrub may be performed per entire row or per one or more columns of a particular row, depending on the device implementation.

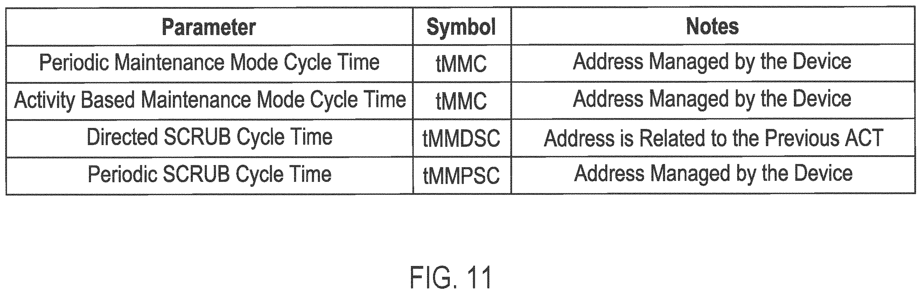

**FIG. 11** shows timing parameters for maintenance mode commands, in accordance with some embodiments. Each maintenance mode command has a timing parameter corresponding to a cycle time for the particular maintenance mode. For each maintenance mode, the addresses on which maintenance operations are performed are managed by a controller. For example, the controller can be an external controller (e.g., ASIC controller) separate from one or more memory dies that are being managed, or the controller can be a local controller on the same memory die as the memory array(s) being managed.

In the case of the directed scrub, the address on which the scrub is performed is determined by the address of the most recently activated row. In the case of the periodic scrub, the address can be determined by an intemal scrub row address pointer. The timing parameters correspond to an internal maintenance mode operation duration for the respective maintenance mode. Some timing parameters correspond to an intemal scrub operation duration for the data path and data correction phases of the respective maintenance mode.

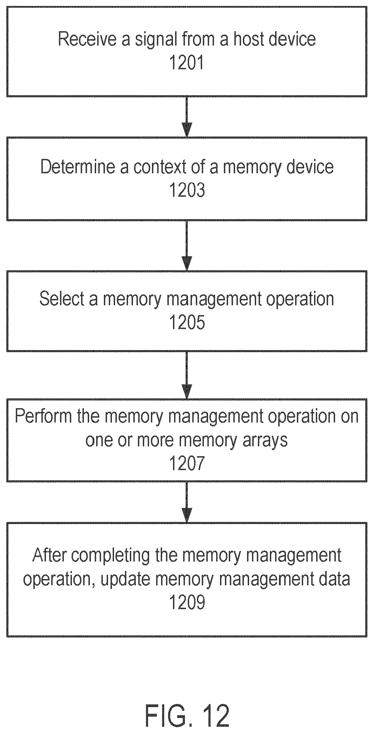

**FIG. 12** shows a method to perform memory management operations on one or more memory arrays, in accordance with some embodiments. For example, the method of **FIG. 12** can be implemented in the memory device 102 of **FIG. 1****.**

The method of **FIG. 12** can be performed by processing logic that can include hardware (e.g., processing device, circuitry, dedicated logic, programmable logic, microcode, hardware of a device, integrated circuit, etc.), software (e.g., instructions run or executed on a processing device), or a combination thereof. In some embodiments, the method of **FIG. 12** is performed at least in part by one or more processing devices (e.g., controller 104 or 105 of **FIG. 1**) and/or by other logic circuitry.

Although shown in a particular sequence or order, unless otherwise specified, the order of the processes can be modified. Thus, the illustrated embodiments should be understood only as examples, and the illustrated processes can be performed in a different order, and some processes can be performed in parallel. Additionally, one or more processes can be omitted in various embodiments. Thus, not all processes are required in every embodiment. Other process flows are possible.

At block 1201, a signal is received from a host device. In one example, the signal is a request from host device 101 to read data stored in memory arrays 106. In response to receiving the request, external controller 104 issues a read command and the memory device 102 performs a read operation.

At block 1203, a context of a memory device is determined. In one example, external controller 104 receives error signals from error correction circuitry 110 based on the read operation performed.

At block 1205, a memory management operation is selected. In one example, controller 104 selects a directed scrub or a periodic scrub based on the error signals received.

At block 1207, the memory management operation is performed on one or more memory arrays. In one example, controller 104 performs a directed scrub of memory array 106. In one example, controller 104 identifies a particular portion of a row on which to perform the directed scrub.

At block 1209, memory management data is updated after completing the memory management operation. In one example, an external controller 10or local controller 105 updates a pointer to an address in memory array 106. In one example, an internal row address counter is incremented.

In some aspects, the techniques described herein relate to an apparatus including: at least one memory array (e.g., 106); and at least one external and/or local controller (e.g., external controller 104 or local controller 105) configured to: perform a read operation to read first data stored in a row of the memory array; determine that at least one error exists in the read first data; and in response to determining that the error exists, perform a scrubbing operation (e.g., a directed scrub) on at least a portion of the row.

In some aspects, the techniques described herein relate to an apparatus, wherein the read operation is for a host device (e.g., 101), and the scrubbing operation is performed prior to performing any other operation for the host device that requires accessing the row.

In some aspects, the techniques described herein relate to an apparatus, wherein the read operation is performed for a host device, and the scrubbing operation is performed without requiring data transfer from the host device.

In some aspects, the techniques described herein relate to an apparatus, wherein the read operation is for a bank of the memory array, and the row is the row of the bank last accessed prior to performing the scrubbing operation.

In some aspects, the techniques described herein relate to an apparatus, wherein the read operation is performed in response to receiving a read command from a host device.

In some aspects, the techniques described herein relate to an apparatus, wherein the scrubbing operation is performed for all data stored in the row.

In some aspects, the techniques described herein relate to an apparatus, wherein the scrubbing operation is performed only for memory cells of the row that store the first data.

In some aspects, the techniques described herein relate to an apparatus, wherein the memory array is configured in a memory device, and the scrubbing operation is performed further in response to determining a context of the memory device.

In some aspects, the techniques described herein relate to an apparatus, further including at least one sensor (e.g., 150), wherein the context is based on temperature data from the sensor.

In some aspects, the techniques described herein relate to an apparatus including: error correction circuitry (e.g., 110); and at least one external and/or local controller configured to: determine at least one characteristic associated with accessing data in a memory array; and select, based on the determined characteristic, a memory management operation to perform using the error correction circuitry.

In some aspects, the techniques described herein relate to an apparatus, wherein the characteristic is determined based on at least one signal provided by the error correction circuitry (e.g., ECC error alert signal (EEA)).

In some aspects, the techniques described herein relate to an apparatus, wherein the characteristic is an error rate for the accessed data (e.g., raw bit error rate (RBER)).

In some aspects, the techniques described herein relate to an apparatus, wherein the controller is further configured to compare the determined characteristic to a threshold, and the memory management operation is selected based on the comparison.

In some aspects, the techniques described herein relate to an apparatus, wherein the threshold is at least one of a number of errors, or the threshold is a level of activity (e.g., a number of accesses to a portion of memory, or a number of row activations).

In some aspects, the techniques described herein relate to an apparatus, wherein the characteristic is associated with accessing data in a first bank of a memory array, and the memory management operation is performed on the first bank in parallel with access by the controller to at least one other bank of the memory array.

In some aspects, the techniques described herein relate to an apparatus, further including at least one mode register (e.g., 160), wherein the memory management operation is selected further based on configuration data stored in the mode register.

In some aspects, the techniques described herein relate to a method including: triggering, based on a timer (e.g., a timer implemented by controller 104), a scrubbing operation for at least one address in a memory; and performing the scrubbing operation by correcting data stored at the address.

In some aspects, the techniques described herein relate to a method, wherein the address is determined using a counter (e.g., a counter implemented by controller 104), the method further including incrementing the counter after performing the scrubbing operation.

In some aspects, the techniques described herein relate to a method, wherein the address is determined by random sampling of an address space in the memory.

In some aspects, the techniques described herein relate to a method, wherein the scrubbing operation is performed on at least one first bank of the memory, and the scrubbing operation is performed in parallel with a memory management operation performed on at least one second bank of the memory.

In some aspects, the techniques described herein relate to a method, wherein the scrubbing operation is performed on rows in multiple banks.

In one example, memory device operation includes issuance of various commands. Non-limiting details regarding certain exemplary commands are provided below:
- Memory device operation
   o When activate to row address x is issued
      - The row address x may be addressed by addressing bits on the activate command in the following manner
         - Bank address (to specify which bank within the memory device)
         - Row address (to specify which row within the specified bank)
         - Word line associated with row address x brought high
         - Sense page which causes data to reside in sense amp latches
   o When a read command for column *y* of activated row address x is issued (read command must occur while a row is activated)
      - Summary: read corrected data of the data that resides in the sense amplifier (SA) latches associated with column y
      - Note: read command contains the following addressing bits
         - Bank address (to specify which bank within the memory device)
         - Column address (to specify which column of the activated row within the specified bank)
      - Full details:
         - Note: Column *y* data is represented by the state of the SA latches associated with column y
            - Furthermore, column y is associated with a code word which consists of data bits and parity bits
         - Data and parity from SA latches of the appropriate column fed through a Code Word ECC Engine
         - Error detection
            - Syndrome generated based upon computed (parity calculated from data residing in "data" SA latches) and stored parity (parity stored directly in SA latches)
         - Any correctable errors are corrected
            - SA latch data remains unchanged
            - Data output is corrected
         - Possibly corrected data sent out of memory device on DQs (IO pins) of memory device
   o When a write command for column *y* of activated row address x is issued (write command must occur while a row is activated)
      - Summary: alter SA latches associated with column yto contain new write data and associated parity
      - Note: write command contains the following addressing bits
         - Bank address (to specify which bank within the memory device)
         - Column address (to specify which column of the activated row within the specified bank)
      - Full details
         - Data input from DQs (IO pins) of memory device
         - Data fed through Code Word ECC Engine
            - Parity generated based upon input data
         - Input data and generated parity (code word) written into the SA latches of the appropriate column
   o When precharge command is issued
      - Summary: A precharge command will result in an implicit write to the cells and then the word line is brought low
         - The cells will now contain the data (all the data and all the parity of all the code words) residing with the SA latches
      - Note: precharge command contains the following addressing bits
         - Bank address (whatever row is activated in the bank is precharged)
      - Full details:
         - Write page data into memory cells
            - Data residing within all SA latches written to memory cells
         - Word line associated with row address x brought low after data is written into the memory cells

A non-limiting example of a memory device is now described.
- Various details regarding use of a code word ECC engine are presented below:
   ∘ Various details are provided below as to the operation and behavior of the memory device:
      - Memory array behavior
         - On activate commands (ACTs): Sense page of memory array which causes data to reside in sense amplifier (or simply "sense amp") latches
         - On precharge commands (PREs): Write data in sense amp latches into page of memory array
      - Code Word ECC Engine behavior
         - On Writes
            ∘ Data input from DQs (IO pins) of memory device
            ∘ Data fed through Code Word ECC Engine
               - Parity generated based upon input data
            ∘ Input data and generated parity (code word) written into the sense amplifier (SA) latches of the appropriate column
         - On Reads
            ∘ Data from SA latches of the appropriate column fed through Code Word ECC Engine
            ∘ Syndrome generated based upon computed and stored parity (error detection)
            ∘ Any correctable errors are corrected
               - SA latch data remains unchanged
               - Data output is corrected
            ∘ Possibly corrected data sent out of memory device on DQs

The disclosure includes various devices which perform the methods and implement the systems described above, including data processing systems which perform these methods, and computer-readable media containing instructions which when executed on data processing systems cause the systems to perform these methods.

The description and drawings are illustrative and are not to be construed as limiting. Numerous specific details are described to provide a thorough understanding. However, in certain instances, well-known or conventional details are not described in order to avoid obscuring the description. References to one or an embodiment in the present disclosure are not necessarily references to the same embodiment; and, such references mean at least one.

As used herein, "coupled to" or "coupled with" generally refers to a connection between components, which can be an indirect communicative connection or direct communicative connection (e.g., without intervening components), whether wired or wireless, including connections such as electrical, optical, magnetic, etc.

Reference in this specification to "one embodiment" or "an embodiment" means that a particular feature, structure, or characteristic described in connection with the embodiment is included in at least one embodiment of the disclosure. The appearances of the phrase "in one embodiment" in various places in the specification are not necessarily all referring to the same embodiment, nor are separate or alternative embodiments mutually exclusive of other embodiments. Moreover, various features are described which may be exhibited by some embodiments and not by others. Similarly, various requirements are described which may be requirements for some embodiments but not other embodiments.

In this description, various functions and/or operations may be described as being performed by or caused by software code to simplify description. However, those skilled in the art will recognize what is meant by such expressions is that the functions and/or operations result from execution of the code by one or more processing devices, such as a microprocessor, Application-Specific Integrated Circuit (ASIC), graphics processor, and/or a Field-Programmable Gate Array (FPGA). Alternatively, or in combination, the functions and operations can be implemented using special purpose circuitry (e.g., logic circuitry), with or without software instructions. Embodiments can be implemented using hardwired circuitry without software instructions, or in combination with software instructions. Thus, the techniques are not limited to any specific combination of hardware circuitry and software, nor to any particular source for the instructions executed by a computing device.

While some embodiments can be implemented in fully functioning computers and computer systems, various embodiments are capable of being distributed as a computing product in a variety of forms and are capable of being applied regardless of the particular type of computer-readable medium used to actually effect the distribution.

At least some aspects disclosed can be embodied, at least in part, in software. That is, the techniques may be carried out in a computing device or other system in response to its processing device, such as a microprocessor, executing sequences of instructions contained in a memory, such as ROM, volatile RAM, non-volatile memory, cache or a remote storage device.

Routines executed to implement the embodiments may be implemented as part of an operating system, middleware, service delivery platform, SDK (Software Development Kit) component, web services, or other specific application, component, program, object, module or sequence of instructions (sometimes referred to as computer programs). Invocation interfaces to these routines can be exposed to a software development community as an API (Application Programming Interface). The computer programs typically comprise one or more instructions set at various times in various memory and storage devices in a computer, and that, when read and executed by one or more processors in a computer, cause the computer to perform operations necessary to execute elements involving the various aspects.

A computer-readable medium can be used to store software and data which when executed by a computing device causes the device to perform various methods. The executable software and data may be stored in various places including, for example, ROM, volatile RAM, non-volatile memory and/or cache. Portions of this software and/or data may be stored in any one of these storage devices. Further, the data and instructions can be obtained from centralized servers or peer to peer networks. Different portions of the data and instructions can be obtained from different centralized servers and/or peer to peer networks at different times and in different communication sessions or in a same communication session. The data and instructions can be obtained in entirety prior to the execution of the applications. Alternatively, portions of the data and instructions can be obtained dynamically, just in time, when needed for execution. Thus, it is not required that the data and instructions be on a computer-readable medium in entirety at a particular instance of time.

Examples of computer-readable media include, but are not limited to, recordable and non-recordable type media such as volatile and non-volatile memory devices, read only memory (ROM), random access memory (RAM), flash memory devices, solid-state drive storage media, removable disks, magnetic disk storage media, optical storage media (e.g., Compact Disk Read-Only Memory (CD ROMs), Digital Versatile Disks (DVDs), etc.), among others. The computer-readable media may store the instructions. Other examples of computer-readable media include, but are not limited to, non-volatile embedded devices using NOR flash or NAND flash architectures. Media used in these architectures may include un-managed NAND devices and/or managed NAND devices, including, for example, eMMC, SD, CF, UFS, and SSD.

In general, a non-transitory computer-readable medium includes any mechanism that provides (e.g., stores) information in a form accessible by a computing device (e.g., a computer, mobile device, network device, personal digital assistant, manufacturing tool having a controller, any device with a set of one or more processors, etc.). A "computer-readable medium" as used herein may include a single medium or multiple media (e.g., that store one or more sets of instructions).

In various embodiments, hardwired circuitry may be used in combination with software and firmware instructions to implement the techniques. Thus, the techniques are neither limited to any specific combination of hardware circuitry and software nor to any particular source for the instructions executed by a computing device.

Various embodiments set forth herein can be implemented using a wide variety of different types of computing devices. As used herein, examples of a "computing device" include, but are not limited to, a server, a centralized computing platform, a system of multiple computing processors and/or components, a mobile device, a user terminal, a vehicle, a personal communications device, a wearable digital device, an electronic kiosk, a general purpose computer, an electronic document reader, a tablet, a laptop computer, a smartphone, a digital camera, a residential domestic appliance, a television, or a digital music player. Additional examples of computing devices include devices that are part of what is called "the internet of things" (IOT). Such "things" may have occasional interactions with their owners or administrators, who may monitor the things or modify settings on these things. In some cases, such owners or administrators play the role of users with respect to the "thing" devices. In some examples, the primary mobile device (e.g., an Apple iPhone) of a user may be an administrator server with respect to a paired "thing" device that is wom by the user (e.g., an Apple watch).

In some embodiments, the computing device can be a computer or host system, which is implemented, for example, as a desktop computer, laptop computer, network server, mobile device, or other computing device that includes a memory and a processing device. The host system can include or be coupled to a memory sub-system so that the host system can read data from or write data to the memory sub-system. The host system can be coupled to the memory sub-system via a physical host interface. In general, the host system can access multiple memory sub-systems via a same communication connection, multiple separate communication connections, and/or a combination of communication connections.

In some embodiments, the computing device is a system including one or more processing devices. Examples of the processing device can include a microcontroller, a central processing unit (CPU), special purpose logic circuitry (e.g., a field programmable gate array (FPGA), an application specific integrated circuit (ASIC), etc.), a system on a chip (SoC), or another suitable processor.

In one example, a computing device is a controller of a memory system. The controller includes a processing device and memory containing instructions executed by the processing device to control various operations of the memory system.

Although some of the drawings illustrate a number of operations in a particular order, operations which are not order dependent may be reordered and other operations may be combined or broken out. While some reordering or other groupings are specifically mentioned, others will be apparent to those of ordinary skill in the art and so do not present an exhaustive list of alternatives. Moreover, it should be recognized that the stages could be implemented in hardware, firmware, software or any combination thereof.

Disjunctive language such as the phrase "at least one of X, Y, or Z," unless specifically stated otherwise, is otherwise understood with the context as used in general to present that an item, term, etc., may be either X, Y, or Z, or any combination thereof (e.g., X, Y, and/or Z). Thus, such disjunctive language is not generally intended to, and should not, imply that certain embodiments require at least one of X, at least one of Y, or at least one of Z to each be present.

In the foregoing specification, the disclosure has been described with reference to specific exemplary embodiments thereof. It will be evident that various modifications may be made thereto without departing from the broader scope as set forth in the following claims. The specification and drawings are, accordingly, to be regarded in an illustrative sense rather than a restrictive sense.

## Claims

1. An apparatus comprising:
at least one memory array of a memory die; and
at least one controller configured to:
issue a read command to the memory die to perform a read operation to read first data stored in a row of the memory array;
determine, based on at least one signal from error correction circuitry of the memory die, that at least one error exists in the read first data; and
in response to determining that the error exists, issue a memory management command to the memory die to perform a directed scrub on at least a portion of the row.

2. The apparatus of claim 1, wherein the read operation is for a host device, the row is a first row in a bank of the memory array, and the directed scrub is performed prior to performing any other operation for the host device that requires accessing the first row or any other row of the bank.

3. The apparatus of claim 1, wherein the read operation is performed for a host device, and the directed scrub is performed without requiring data transfer.

4. The apparatus of claim 1, wherein the read operation is for a bank of the memory array, and the row is the row of the bank last accessed prior to performing the directed scrub.

5. The apparatus of claim 1, wherein:
the memory die has a local controller configured to, in response to receiving the memory management command, perform a scrub to one or more banks associated with the memory management command; and
the scrub is performed to the last activate address for each bank.

6. The apparatus of claim 1, wherein the directed scrub is performed for all data stored in the row.

7. The apparatus of claim 1, wherein the directed scrub is performed only for memory cells of the row that store the first data.

8. The apparatus of claim 1, further comprising at least one sensor, wherein the directed scrub is performed in response to determining a context of at least one of the controller or the memory die, and the context is based on temperature data from the sensor.

9. The apparatus of claim 1, wherein the controller is further configured to:
determine at least one characteristic associated with accessing data in a memory array; and
select, based on the determined characteristic, a memory management operation to perform.

10. The apparatus of claim 9, wherein:
the characteristic is determined based on at least one signal provided by the error correction circuitry;
the characteristic is an error rate for the accessed data;
the controller is further configured to compare the determined characteristic to a threshold, and the memory management operation is selected based on the comparison; and
the threshold is at least one of a number of errors, or the threshold is a level of activity.

11. The apparatus of claim 9, further comprising at least one mode register, wherein:
the characteristic is associated with accessing data in a first bank of a memory array, and the memory management operation is performed on the first bank in parallel with access by the controller to at least one other bank of the memory array; and
the memory management operation is selected further based on configuration data stored in the mode register, and on configuration bits of a memory management command.

12. A method comprising:
triggering, by an external or local controller based on a timer, a scrubbing operation for at least one address in a memory; and
performing the scrubbing operation by correcting data stored at the address.

13. The method of claim 12, wherein the address is determined using a counter, the method further comprising incrementing the counter after performing the scrubbing operation.

14. The method of claim 12, wherein the address is determined by random sampling of an address space in the memory.

15. The method of claim 12, wherein the scrubbing operation is performed on at least one first bank of the memory, and the scrubbing operation is performed in parallel with a memory management operation performed on at least one second bank of the memory.
